# EUROPEAN PATENT APPLICATION

(11) **EP 2 634 229 A2**
(43) Date of publication of application: **04.09.2013**
(21) Application number: 13157125.9
(22) Date of filing: 28.02.2013
(51) Int. Cl.: C09J 7/02

(54) **Self-rolling adhesive film**

(30) Priority: 29.02.2012 JP 2012044235
(71) Applicant: NITTO DENKO CORPORATION, Ibaraki-shi, Osaka 567-8680 (JP)
(72) Inventor: Kiuchi, Kazuyuki, Ibaraki-shi, Osaka 567-8680 (JP); Nishio, Akinori, Ibaraki-shi, Osaka 567-8680 (JP); Kawanishi, Michirou, Ibaraki-shi, Osaka 567-8680 (JP)
(74) Representative: Grünecker, Kinkeldey, Stockmair & Schwanhäusser

(57) **Abstract**

In detachment by self-rolling, if the leading end of the rolling adhesive layer comes into contact with the rear surface thereof, which is not an adhesive layer side of an easily detachable adhesive sheet, the diameter of the circular cross section of a roll cannot be reduced. If so, the detachment angle is lowered. Because of this, it becomes difficult to minimize detachment stress and the amount of remaining glue increases.

Furthermore, if rolling into a cylindrical roll is stopped in the middle, for example, the shape of a roll becomes unstable. Consequently, it is difficult to smoothly deform into a cylindrical roll and subsequently collect an easy detachable adhesive sheet. Besides these, since stress is concentrated to a local point, there is a high possibility of breaking a workpiece. A self-rolling adhesive film formed by laminating a substrate film formed of a laminate having at least one thermal contraction film and an adhesive layer on a surface of the substrate film, not formed of a thermal contraction film, in which shear stress between the surface of the thermal contraction film of the substrate film and the adhesive layer thereof is 240 g/mm² or less.

## Description

### BACKGROUND OF THE INVENTION

### Field of the Invention

The present invention relates to an adhesive film capable of deforming into a cylindrical shape by heating and maintaining the deformed shape.

### Description of the Related Art

Up to present, the present inventors have developed easily detachable adhesive sheets using a laminate formed of a thermal contraction film layer, a bonding-agent layer (adhesive layer) and a rigid resin film layer as a substrate (Japanese Patent Laid-Open No. 2010-194819 and Japanese Patent No. 4151850).
This sheet is characterized in that contraction stress which is generated by heating the substrate is converted into torque in the laminate to detach the adhesive sheet from a workpiece as if the adhesive sheet is detached (peeled) by hand, and in that the adhesive tape detached forms a cylindrical shape.
In order to put the sheet effectively into practical use, such cylindrical shaped pieces must be easily collected. More specifically, the cylindrical shaped pieces detached must maintain the cylindrical shape. This is because, to collect the cylindrically deformed sheets by a practically useful method, collection by use of a detachment tape, picking-up by a robot arm or the like and blowing-off by wind are conceivable (Japanese Patent Laid-Open No. 2011-54641); however, in any method, if cylindrical shaped pieces are easily deformed by application of stress of these collection operations, the adhesive sheet may attach again to a workpiece, with the result that it becomes difficult to collect the pieces.

The inventions of these easily detachable adhesive sheets are each directed to facilitating collection of the adhesive sheet by deforming it into a cylindrical shape by heating. To attain detachment with low stress by forming a stable cylindrical shape in a good yield for short time, it is necessary to increase detachment strength. To attain this, it is preferred to reduce the diameter of the circular cross section of the rolled cylindrical structure. In short, the easy detachable adhesive sheet need to be tightly rolled to make a compact roll.
However, in detaching a self-roll sheet, if the adhesive layer of the leading end of the roll comes into contact with the back surface thereof (which is not an adhesive layer side of an easily detachable adhesive sheet) and gets stuck therein, the diameter of the circular cross section of the roll cannot be reduced. If so, the detachment angle is lowered. Because of this, it becomes difficult to minimize detachment stress and the amount of remaining glue increases.
Furthermore, if rolling to a cylindrical roll is stopped in the middle, for example, the shape of a roll becomes unstable. Consequently, it is difficult to smoothly deform into a cylindrical roll and subsequently collect an easy detachable adhesive sheet. Besides these, since stress is concentrated into a local point, there is a high possibility of breaking a workpiece.

### SUMMARY OF THE INVENTION

1. A self-rolling adhesive film comprising an adhesive layer laminated on a substrate film comprising a laminate having a thermal contraction film as one of the surfaces thereof, wherein the adhesive layer is laminated on a surface of the substrate film, not formed of the thermal contraction film, and shear stress between the surface of the thermal contraction film and the adhesive layer is 240 g/mm² or less.
2. The self-rolling adhesive film according to item 1, in which the thermal contraction film has a contraction percentage of 30 to 90% in the main contraction direction at a predetermined temperature within the range of 70 to 180°C.
3. The self-rolling adhesive film according to item 1, in which the multi-layered substrate includes a rigid film and the rigid film has a product obtained by multiplying the Young's modulus of the rigid film at 80°C and a thickness thereof of 3.0 × 10⁵ N/m or less.
4. The self-rolling adhesive film according to item 3, in which the thermal contraction film has a contraction percentage of 30 to 90% in the main contraction direction at a predetermined temperature within the range of 70 to 180°C and the product obtained by multiplying the Young's modulus of the rigid film at 80°C and a thickness thereof is 3.0 × 10⁵ N/m or less.
5. The self-rolling adhesive film according to item 1, rolling by itself unidirectionally from one end or from two ends facing each other toward the center by heating to form one or two cylindrical rolls.
6. The self-rolling adhesive film according to item 1, wherein a ratio of (r/L), which is a ratio of diameter r of the cylindrical roll to be formed and the original length L of the self-rolling adhesive film cylindrically rolled, is 0.0001 to 0.999.
7. The self-rolling adhesive film according to any one of items 1 to 6, obtained by sequentially laminating the thermal contraction film, the bonding-agent layer, the rigid film and the adhesive layer in this order.
8. The self-rolling adhesive film according to any one of items 1 to 6, including organic coating layer between the rigid film and the adhesive layer.
9. The self-rolling adhesive film according to any one of items 1 to 6, in which the adhesive layer is energy-ray curable or pressure-sensitive type.
10. The self-rolling adhesive film according to any one of items 1 to 6, in which detachment force (180° detachment by peel strength, tension rate: 300 mm/minute) required for detachment between the thermal contraction film and the rigid film at 70°C is 2.0 N/10 mm or more.
11. A method for processing a workpiece, comprising bonding the self-rolling adhesive film according to any one of items 1 to 10 to a workpiece, reducing the thickness of the workpiece surface on which the self-rolling adhesive film is not bonded, heating the self-rolling adhesive film to roll the self-rolling adhesive film, thereby detaching the self-rolling adhesive film from the workpiece.
12. A method for processing a workpiece, comprising bonding the self-rolling adhesive film according to any one of items 1 to 10 to a workpiece, cutting the workpiece, heating the self-rolling adhesive film to roll the self-rolling adhesive film, thereby detaching the self-rolling adhesive film from the workpiece.

According to the present invention, a self-rolling adhesive film can be rolled without fail. Besides this, since the detachment angle of the self-rolling adhesive film to a workpiece increases, detachment stress can be reduced. As a result, the amount of remaining glue of the workpiece surface reduces and the yield of workpiece increases.
In addition, by applying a self-rolling adhesive film to a silicon wafer as thin as 100 µm or less, a fragile workpiece such as a fragile wafer formed of e.g., a compound semiconductor such as GaAs, breakage in detachment or the like can be prevented. In addition, since a self-rolling adhesive film is rolled in a compact state, handling of the rolled film in collecting and discarding can be improved.

### BRIEF DESCRIPTION OF THE DRAWINGS

FIG. 1 is a sectional view of a film of the present invention;
FIG. 2 is a sectional view of the adhesive film of the present invention;
FIG. 3 shows an aspect of rolling the film and adhesive film of the present invention;
FIG. 4 is a conceptual view of a method for measuring shear stress;
FIG. 5 shows an aspect of rolling the film and adhesive film of the present invention;
FIG. 6 shows rolling of the adhesive film of the present invention when it is used as a surface protective sheet in dicing;
FIG. 7 shows a conceptual view in returning a cylindrical shaped piece into an original flat film; and FIG. 8 shows a method for measuring a necessary load.

### DETAILED DESCRIPTION OF THE PREFERRED EMBODIMENTS

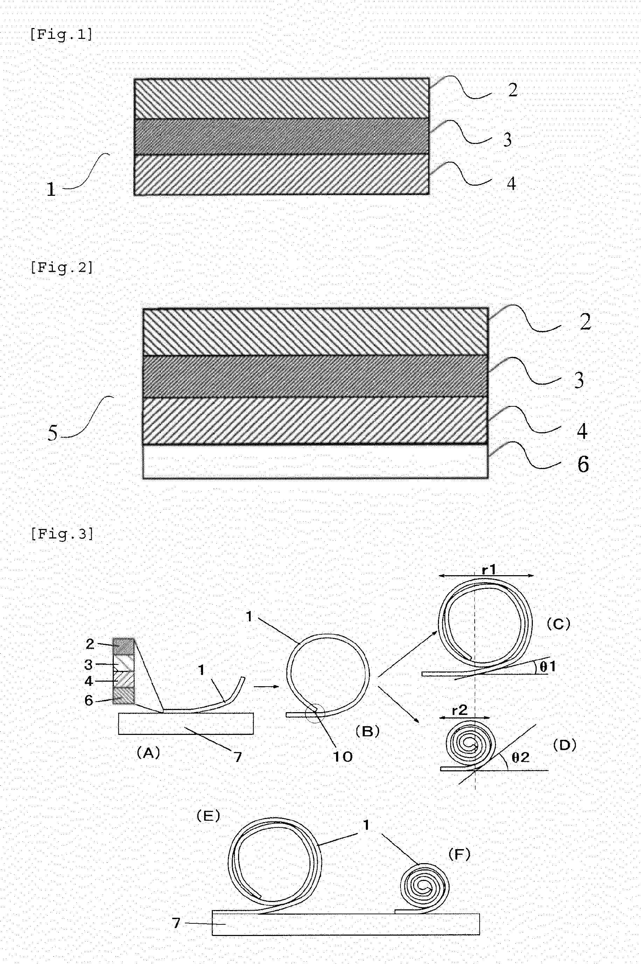

The present invention will be described below with reference to the accompanying drawings. FIG. 1 is a sectional view showing a film serving as a substrate for the self-rolling adhesive film of the present invention (hereinafter simply referred to as the "adhesive film"). FIG. 2 is a sectional view showing the adhesive film of the present invention. In FIG. 1, a film 1 is prepared by laminating a thermal contraction film 2 having thermal contractility and a rigid film 4, which constrains contraction of the thermal contraction film 2, with a bonding-agent layer 3 interposed between them. Furthermore, in FIG. 2, an adhesive film 5 is prepared by laminating an adhesive layer 6 on the rigid film 4 of the film shown in FIG. 1. In this case, the film 1 serves as a support substrate for the adhesive film 5.

In the present invention, the self-rolling property refers to a property of rolling by itself by application of a stimulus such as heat without particularly requiring subsequent external force to form a roll. As the stimulus facilitating self-rolling, e.g., heat, light and electricity are mentioned; however, particularly heat is preferable. Note that the support tape is preferably rolled by application of a stimulus such as heat to form a complete cylindrical roll (both ends overlap with each other); however, an incomplete cylindrical roll (both ends are not overlapped and a part of the cylinder is opened lengthwise) is acceptable as long as that the self-rolling adhesive film can achieve the object of the present invention.
The self-rolling occurs in accordance with the following mechanism: When a film having a contractive surface on one side is contracted, the film cannot be uniformly contracted and deforms into a cylindrical shape with the non-contractile surface exposed outside. The resultant cylindrical object has physical strength owing to the physical properties of the non-contractile material of the outer surface.

As the thermal contraction film 2, any film layer may be used as long as it has at least uniaxial contractility, and may be formed of e.g., a thermal contraction film, a photo contraction film or an electrical contraction film. Of them, a thermal contraction film is preferable in view of e.g., working efficiency. The thermal contraction film 2 may have uniaxial contractility or may have main contractility in a predetermined direction (uniaxial contractility) and additional contractility in a different direction (for example, the direction perpendicular to the predetermined direction). The thermal contraction film 2 may be formed of a single layer or multiple layers (consisting of 2 or more layers).

The contraction percentage of the thermal contraction film(s) forming the thermal contraction film 2 in the main contraction direction is preferably 30 to 90%. In the case where the thermal contraction film 2 is constituted of a thermal contraction film, the contraction percentage of the main contraction direction of the thermal contraction film at a predetermined temperature (for example, 95°C, 140°C) within the range of 70 to 180°C is preferably 30 to 90%.

As the thermal contraction film, for example, a uniaxially drawn film formed of one or two or more types of resins selected from polyesters such as poly(ethylene terephthalate); polyolefins such as polyethylene and polypropylene, polynorbornene, polyimide, polyamide, polyurethane, polystyrene, poly(vinylidene chloride) and poly(vinyl chloride). Of them, since coating workability of a bonding agent is excellent, a uniaxially drawn film formed of a polyester resin, a polyolefin resin such as polyethylene, polypropylene and polynorbornene (including a cyclic polyolefin resin) or a polyurethane resin is preferable. As such a thermal contraction film, commercially available products such as "Space clean" manufactured by Toyobo Co., Ltd., "fancy wrap" manufactured by GUNZE LIMITED., "TORAYFAN" manufactured by Toray Industries Inc., "Lumilar" manufactured by Toray Industries Inc. "ARTON" manufactured by JSR Corporation, "ZEONOR" manufactured by ZEON CORPORATION and "SUNTEC" manufactured by Asahi Kasei Corporation can be used.
If such a drawn film is used, the self-rolling adhesive film contracted does not spontaneously return to an original shape. Needless to say, if the self-rolling adhesive film contracted is stretched so as to elongate, the shape of the self-rolling adhesive film becomes closer to an original planar shape. Based on the tensile force applied at this time, Young's modulus can be obtained.

Note that, in the case where the film 1 is used as a support substrate for the adhesive film 5 having the energy-ray curable adhesive layer 6, when the energy-ray curable adhesive layer is cured by irradiation of energy ray through the thermal contraction film 2, the thermal contraction film 2 needs to be formed of a material that can transmit a predetermined amount or more of energy ray (for example, a transparent resin).

The thickness of the thermal contraction film 2 is generally 5 to 300 µm and preferably 10 to 100 µm. If the thickness of the thermal contraction film 2 falls within the range, the film 1 dose not have excessively increased rigidity and can be deformed into a cylindrical shape. In addition, since the thermal contraction film 2 and the rigid film 4 are not separated, breakage of the film 1 does not occur. It is known that, in a highly rigid film, significant elastic deformation occurs due to remaining stress in bonding films and that warpage tends to be high when the thickness of a wafer is reduced. In order to enhance the adhesion property to an adjacent layer and retention ability, the surface of the thermal contraction film 2 may be treated with a conventional surface treatment such as a chemical or physical treatment including a chromic acid treatment, ozone exposure, flame exposure, high pressure electric shock exposure and ionization radiation treatment and a coating treatment with a sealer (for example, adhesive material).

The rigid film 4 constrains contraction of the thermal contraction film 2 to produce counteracting force. In this manner, torque of the entire film is produced and used as driving force of rolling. Furthermore, additional contraction is suppressed by the rigid film 4 from occurring in a different direction from the main contraction direction of the thermal contraction film 2. Thus, it is conceivable that the rigid film 4 has a function of converging contraction directions of the thermal contraction film 2 (contraction of which is said to occur uniaxially; however, actually, contraction may not always occur unidirectionally) into a single direction. Because of this, if a stimulus such as heat for facilitating contraction of the thermal contraction film 2 is applied to the film 1, repulsion force is produced in the rigid film 4 against contraction force of the thermal contraction film 2 and serves as driving force to lift up the outer peripheral portion of the film 1 (one end portion or two end portions facing each other). As a result, the film 1 rolls by itself from the end portion, with the thermal contraction film 2 inward, unidirectionally or toward the center (usually, along the main contraction axis of the thermal contraction film) to deform into a cylindrical shape. Moreover, shearing force produced by contraction deformation of the thermal contraction film 2 can be suppressed by the rigid film 4 from transmitting to the adhesive layer 6 and a workpiece. Thus, breakage of the adhesive layer 6 (for example, cured adhesive layer) reduced in adhesive force during re-detachment time, breakage of the workpiece, and contamination of the workpiece with the broken adhesive layer 6 can be prevented.

By providing the rigid film 4, when a stimulus such as heat causing contraction is applied to the thermal contraction film 2, a laminate sheet or an adhesive film can be smoothly self-rolled without stopping in the middle or without going off the direction to obtain a fine shaped cylindrical roll.
The product obtained by multiplying the Young's modulus of the rigid film layer and a thickness thereof (Young's modulus × thickness) is preferably 3.0 × 10⁵ N/m or less (for example, 1.0 × 10² to 3.0 × 10⁵ N/m) at the temperature (for example, 80°C) at which detachment occurs and further preferably 2.8 ×10⁵ N/m or less (for example, 1.0 × 10³ to 2.8 × 10⁵ N/m). Owing to this, a function of converting the contraction stress of the contractive film layer into rolling stress and function of converging the contraction directions can be ensured. In addition, owing to this, the rigid film layer is avoided to be excessively rigid and swift rolling can be facilitated with the help of the thickness of the aforementioned bonding-agent layer.
The Young's modulus of the rigid film layer is preferably 10 GPa or less at the temperature (for example, 80°C) at which detachment occurs and further preferably 5 GPa or less. If the Young's modulus falls within the range, self-rolling can be facilitated to obtain a fine-shaped cylindrical roll. Note that, the Young's modulus can be determined in accordance with e.g., the method described in JIS-K7127.

The thickness of the rigid film layer is suitably, e.g., about 5 to 100 µm and preferably about 8 to 50 µm. Owing to this, self-rolling properties can be ensured to obtain a fine-shaped cylindrical roll. Furthermore, handling and economic efficiency can be improved. It is preferred that the rigid film layer can be easily controlled in thickness in view of productivity and/or workability and is excellent in moldability and processability, in short, easily formed into a film.
Note that, as described later, as the adhesive layer of a self-rolling adhesive sheet, an energy-ray curable adhesive is suitably used. Since the energy-ray curable adhesive is cured by irradiation of energy ray through the rigid film layer, the rigid film layer is preferably formed of a material that can transmit a predetermined amount or more of energy ray (for example, a material that can transmit 90% or more, 80% or more or 70% or more of energy ray used such as a transparent resin).

Examples of the film constituting the rigid film 4 include films formed of one or two or more types of resins selected from polyesters such as poly (ethylene terephthalate), poly(butylene terephthalate) and poly(ethylene naphthalate); polyolefins such as polyethylene and polypropylene; polyimides; polyamides; polyurethanes; styrene resins such as polystyrenes; poly(vinylidene chloride); and poly(vinyl chloride) and others. Of them, since e.g., coating workability of an adhesive is excellent, polyester resin films, polypropylene films, polyamide films and others are preferable. The rigid film 4 may be a single layer or a multi-layer in which 2 or more layers are laminated. The film(s) constituting the rigid film 4 is non-contractility and the contraction percentage is, for example, 5% or less, preferably 3% or less and further preferably 1% or less.

Since the rigid film 4 constrains the contraction of the thermal contraction film 2, it has elastic adhesiveness (including stickiness). Furthermore, it is preferable that the rigid film 4 is more or less tough or rigid to smoothly form a cylindrical roll. The rigid film 4 may be formed of a single layer or a multi-layer whose function is shared by a plurality of layers.

In the examples shown in FIG. 1 and FIG. 2, the bonding-agent layer 3 is non-thermal contractive similarly to the rigid film 4.
The bonding-agent layer 3 is preferably deformable at a temperature at which the thermal contraction film 2 contracts (at a temperature at which the adhesive film detaches when a self-rolling laminate sheet is used as the support substrate of a self-rolling adhesive film) and more specifically, is in a rubber state. However, if the bonding-agent layer 3 is formed of a flowable material, sufficient counteracting force is not produced and ultimately a thermal contraction film contracts by itself and deformation (self-rolling) cannot occur. Accordingly, the bonding-agent layer 3 is preferably less flowable by means of e.g., a three-dimensional linkage. Furthermore, the thickness of the bonding-agent layer 3 contributes to standing against a weak component of nonuniform contraction force of the thermal contraction film 2 to prevent contraction deformation caused by the weak component of the force. In this manner, nonuniform contraction is changed into unidirectional contraction. After polishing a wafer, warpage occurs. This is conceivably caused by remaining stress in bonding the adhesive film to the wafer. More specifically, the remaining stress elastically deforms the thermal contraction film to cause warpage. The bonding-agent layer also serves to mitigate the remaining stress, thereby reducing warpage.

Accordingly, the bonding-agent layer 3 is desirably formed of a resin having adhesiveness and a glass transition temperature of, for example, 50°C or less, preferably room temperature (25°C) or less, and more preferably 0°C or less. The adhesive force of the surface of the bonding-agent layer 3 facing a thermal contraction film 2 preferably falls 0.5 N/10 mm or more in terms of value measured by 180° peel detachment test (performed in accordance with JIS Z 0237, tension rate: 300 mm/minute, 50°C). If the adhesive force falls within the range, no detachment occurs between the thermal contraction film 2 and the bonding-agent layer 3.
Furthermore, if the detachment force required for detachment between the thermal contraction film 2 and the rigid film 4 (180° peel strength at 70°C, tension rate: 300 mm/minute) is 2.0 N/10 mm or more and preferably 4.0 N/10 mm or more, the thermal contraction film 2 and the rigid film 4 are not separated throughout a rolling step.

Furthermore, the shearing storage elastic modulus G' of the bonding-agent layer 3 is preferably 1 × 10⁴ Pa to 5 × 10⁶ Pa (particularly, 0.05 × 10⁶ Pa to 3 × 10⁶ Pa) at a temperature from room temperature to the temperature at which detachment occurs (for example, 80°C).
The higher the shearing storage elastic modulus, the easier the contraction force is converted into torque. However, if the elastic modulus is excessively high, it becomes difficult to deform into a cylindrical shape by torque. The thickness of the bonding-agent layer 3 should be determined based on the thickness at which adhesion force is sufficiently produced; however, the thickness is preferably about 0.01 to 150 µm and more preferably about 0.1 to 10 µm. If the thickness falls within the range, deformability to a cylindrical shape is maintained and handling and economic efficiency are excellent.

Furthermore, the bonding-agent layer 3 is formed of a material through which an energy ray easily transmits in the case where the adhesive layer 6 is an energy-ray curable adhesive layer. In view of e.g., productivity and workability, a material having excellent moldability (i.e., easily formed into a film) and processability and capable of appropriately controlling the thickness of the resultant film is preferable.

As the bonding-agent layer 3, for example, a resin film such as a non-expandable resin film (including a sheet) formed of a material such as a rubber and a thermoplastic elastomer can be used. Examples of the adhesive for use in an adhesive treatment include, but not particularly limited to, known adhesives such as an acrylic adhesive, a rubber adhesive, a vinylalkyl ether adhesive, a silicone adhesive, a polyester adhesive, a polyamide adhesive, a urethane adhesive and a styrene-diene block copolymer adhesive. These can be used alone or in combination with two or more types. Particularly, in view of controlling adhesive force, an acryl adhesive is preferably used.
Furthermore, a laminated bonding-agent layer formed of e.g., a urethane bonding agent or a polyester bonding agent can be employed.

The above acrylic adhesive is composed of an acrylic adhesive containing an acrylic polymer as a base polymer and a crosslinking agent serving as an additive. Examples of the acrylic polymer include mono or copolymers of esters of a (meth)acrylic acid and an alkyl such as an ester of a C₁-C₂₀ alkyl and (meth)acrylic acid including methyl (meth)acrylate, ethyl (meth)acrylate, butyl (meth)acrylate, 2-ethylhexyl (meth)acrylate, octyl (meth)acrylate; and copolymers of an ester of (meth)acrylic acid and an alkyl and another copolymerizable monomer [for example, a carboxyl group-or acid anhydride group-containing monomer such as acrylic acid, methacrylic acid, itaconic acid, fumaric acid and maleic anhydride; a hydroxyl group-containing monomer such as 2-hydroxyethyl (meth)acrylate; an amino group-containing monomer such as morpholyl (meth)acrylate; an amide group-containing monomer such as (meth)acrylamide; a cyano group-containing monomer such as (meth)acrylonitrile; and an alicyclic hydrocarbon group-containing (meth)acrylate such as isobornyl (meth)acrylate].

An acrylic polymer can be produced by a known polymerization method, for example, thermal polymerization of a monomer component as mentioned above (and a polymerization initiator) in a solvent and photopolymerization of a monomer component as mentioned above (and polymerization initiator) by light (UV rays) in the absence of a solvent.

Examples of the crosslinking agent include, but not particularly limited to, isocyanate crosslinking agents, melamine crosslinking agents and epoxy crosslinking agents. Other than these, UV-ray (UV) reactive crosslinking agent using e.g., an isocyanate group-containing (meth)acrylate may be used. The addition amount of crosslinking agent is usually about 0.01 to 15 parts by weight and preferably about 0.05 to 12 parts by weight based on the above base polymer (100 parts by weight).

The acrylic adhesive may contain, other than a base polymer and a crosslinking agent, appropriate additives such as a cross-linking promoter, an adhesiveness imparting agent (for example, a rosin derivative resin, a polyterpene resin, a petroleum resin, an oil soluble phenol resin), a thickener, a plasticizer, a filler, an age resister and an antioxidant.

In the bonding-agent layer, for example, a crosslinkable acrylic adhesive described in e.g., Japanese Patent Laid-Open No. 2008-155619 and a bonding agent for lamination such as a polyester bonding agent including VYLON manufactured by Toyobo Co., Ltd. can be used; however, in view of workability or the like, a urethane adhesive used as a dry laminate bonding agent is preferable.
The urethane adhesive is a bonding agent in which a compound having an isocyanate group as a functional group and a compound having a hydroxyl group are mixed to produce a urethane bond through a chemical reaction. Since the urethane bond has strong hydrogen bindability, intermolecular interaction with a molecule to be bonded is strong. Thus, the urethane bonding agent is particularly preferable for bonding a film formed of a polar material. Furthermore, since the intermolecular force between bonding agent molecules is strong, even if the bonding agent is heated, softening rarely occurs. Thus, dependency upon temperature is low.
As the urethane adhesive, a urethane adhesive using an aliphatic urethane having high heat stability is preferable. Furthermore, a urethane adhesive having a rigid cyclic skeleton in combination with a flexible skeleton mainly responsible for bending a molecular chain, such as an ether bond or an ester bond, is preferable.
Specifically, Takerak (registered trade mark) or Takenate (registered trade mark) or the like manufactured by Mitsui Chemicals, Inc., Seika bond (registered trade mark) or the like manufactured by Dainichiseika Color & Chemicals, Mfg. Co., Ltd. and TM569 or the like manufactured by Toyo-Morton, Ltd., can be used.

The above urethane adhesive may be used in combination with a curing accelerator. Organic metal compounds formed of tin, titanium and zirconium and an amine curing accelerator are preferable.
Specific examples of the amine curing accelerator include triethylamine, triethylenediamine, tetramethyl-1,3-butanediamine, ethylmorpholine, diazabicycloundecene and diazabicyclononene. The addition amount of the curing accelerator is 0.001 to 5wt % relative to the urethane prepolymer. If the addition amount falls within the range, the urethane adhesive has appropriate strength and a pot life is not shortened.

The urethane adhesive, similarly to the aforementioned acrylic adhesive, may contain, other than a cross-linking promoter, appropriate additives such as an adhesive imparting agent (for example, a rosin derivative resin, a polyterpene resin, a petroleum resin, an oil soluble phenol resin), a thickener, a plasticizer, a filler, an age resistor and an antioxidant.

As shown in FIG. 3, the self-rolling adhesive film of the present invention is rolled with application of a stimulus such as heating.
FIG. 3A shows a stage at which an end portion of the self-rolling adhesive film bonded to the surface of a workpiece starts detaching from the surface of the workpiece in the beginning of rolling and bends backward. The end portion that bends backward is going to roll by contraction of the thermal contraction film.
The self-rolling adhesive film makes one round by rolling. This state is taken out as FIG. 3B and will be described. In the stage shown in the figure, as the self-rolling adhesive film rolls, the section of the edge portion makes a circle. A part of the self-rolling adhesive film is still bonded to the surface of a workpiece or almost completely detached and the leading end portion of the thermal contraction film is just in contact with the back surface of the self-rolling adhesive film, i.e., thermal contraction film and temporarily gets stuck.
The point at which self-rolling adhesive film is in contact with the back surface thereof is represented by a contact point 10. One round of a roll of the self-rolling adhesive film is ended at the contact point 10. If the leading end of the film gets stuck at the contact point 10 and immobilized, the film is subsequently rolled around the circle (serving as an innermost layer) thus formed. The circular cross-section of the resultant cylinder formed by rolling of the self-rolling adhesive film has a large diameter r1, as shown in FIG. 3C. Alternatively, rolling cannot proceed over the contact point.
In the self-rolling adhesive film forming a cylindrical roll having a large cross-section diameter, the detachment angle θ1 formed between the roll and the workpiece surface at a detachment site reduces. In short, since the detachment (peel) angle is small, the detachment stress applied to the workpiece increases. In the context, a fragile workpiece may possibly be broken. Such a failure is a matter of concern.

There is another case where the self-rolling adhesive film is still bonded to a workpiece surface while the leading end thereof is rolled so as to form a circle (in sectional view); however, the leading end, which is in contact with the back surface thereof (the layer formed of the thermal contraction film of the self-rolling adhesive film) at the contact point 10, is not immobilized.
In such cases,the leading end of the self-rolling adhesive film moves forwards by subsequent rolling movement and slips along the back surface of the layer formed of a thermal contraction film of the self-rolling adhesive film. The contact point 10 moves and the leading end portion continuously moves inside by rolling. In this manner, as rolling proceeds, the cylindrical roll of the self-rolling adhesive film is made compact so as to reduce the outer diameter r2.
As a result, as shown in FIG. 3D, the outer diameter r2 of a cylindrical-shaped self-rolling adhesive film formed by thermal contraction on the surface of a workpiece reduces and the detachment angle θ2 formed between the surface of a workpiece and the self-rolling adhesive film increases as a detachment process proceeds by rolling of the self-rolling adhesive film off from the surface of a workpiece.
By virtue of this, the stress applied to the workpiece decreases to avoid breakage of a fragile workpiece.

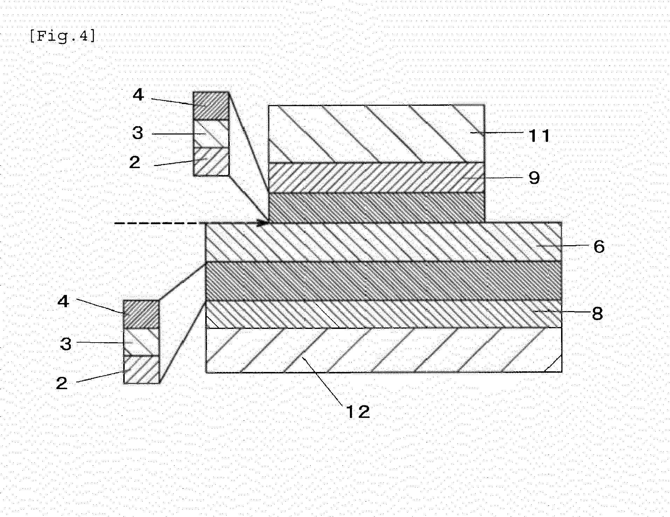

Likewise, when the self-rolling adhesive film, which separates from a workpiece surface and starts rolling, forms a single roll, the leading end of the film comes into contact with the back surface of the self-rolling adhesive film, that is, a layer formed of a thermal contraction film. Thereafter, depending upon whether or not the leading end of the rolled self-rolling adhesive film is immobilized at the contact site, it is determined that either one of the rolled self-rolling adhesive films shown in FIG. 3E or F is formed on the workpiece surface.
In the state shown in FIG. 3E, since the surface area of the rolled self-rolling adhesive film is large, heat is readily emitted from the heated self-rolling adhesive film, with the result that the self-rolling adhesive film is cooled and becomes rarely contracted. The outer diameter tends to further increase. In contrast, in the state of FIG. 3F, since the surface area of the rolled self-rolling adhesive film is small, heat is rarely emitted from the heated self-rolling adhesive film and kept inside, with the result that the elevated temperature is more likely maintained and thus the film is easily contracted. As a result, rolling further proceeds and the outer diameter tends to reduce.
Whether either state is resulted is determined by measuring the shear stress between the surface of the thermal contraction film and the adhesive layer using a sample shown in FIG. 4.

In the self-rolling adhesive film of the present invention, the shear stress between the surface of the thermal contraction film and the adhesive layer is 240 g/mm² or less, preferably 200 g/mm² or less and further preferably 160 g/mm² or less.
If the shear stress measured is 240 g/mm² or less, the leading end of rolled self-rolling adhesive film is not immobilized at the contact site, rolling of the leading end of the self-rolling adhesive film proceeds such that the diameter of the roll reduces and the contact site moves. As a result, the outer diameter of circular cross section of the obtained cylindrical self-rolling adhesive film reduces.
In contrast, if the shear stress measured exceeds 240 g/mm², the leading end of the rolled self-rolling adhesive film is immobilized at the contact site, even if rolling of the self-rolling adhesive film proceeds, the diameter of the circular cross-section of the roll cannot be reduced. In addition, since the contact site is immobilized and does not move, the outer diameter of the circular cross section of the resultant cylindrical self-rolling adhesive film is not reduced.
The lower limit of the shear stress is not particularly limited. The lower the shear stress, the more preferable for detachment. Therefore, the most preferable value (ideal value) is 0 g/mm².

As the adhesive layer 6, an adhesive layer originally having low adhesive force or a bonding-agent layer having low adhesive force can be used. In either case, it is preferable that the adhesive layer 6 has adhesiveness capable of bonding to a workpiece, and that after a predetermined role is completed, the adhesiveness of the adhesive layer 6 can be reduced or disappear by some treatment (adhesiveness reduction treatment). In short, the adhesive layer is preferably re-detachable. Such a re-detachable adhesive layer can be formed in the same manner as the adhesive layer of a known re-detachable adhesive film. In view of self-rolling property, an adhesive force (peel and detach at 180° from a silicon mirror wafer, tension rate: 300 mm/minute) of the adhesive layer or the adhesive layer to which the adhesive reduction treatment is applied is desirably, for example, 50 N/10 mm or less at normal temperature (25°C), preferably 25 N/10 mm or less and more preferably 10 N/10 mm or less.

As the adhesive layer 6, particularly an energy-ray curable adhesive layer is preferable. The energy-ray curable adhesive layer can be formed of a material having adhesiveness in the beginning and capable of forming a three dimensional network structure by irradiation with an energy ray such as infrared rays, visible rays, UV rays, X-rays and electron beams to change into a highly elastic material. As such a material, e.g., an energy-ray curable adhesive can be used. The energy-ray curable adhesive contains a compound chemically modified with an energy-ray reactive functional group for imparting energy-ray curability or an energy-ray curable compound (or energy-ray curable resin). Accordingly, the energy-ray curable adhesive constituted of a composition containing a base agent chemically modified with an energy-ray reactive functional group or a base agent to which an energy-ray curable compound is added is preferably used.

As the base agent, an adhesive material such as a conventionally known pressure sensitive bonding agent (adhesive) can be used. Examples of the adhesive include rubber adhesives using a rubber polymer such as a natural rubber, polyisobutylene rubber, styrene-butadiene rubber, styrene-isoprene-styrene block copolymer rubber, regenerated rubber, butyl rubber, polyisobutylene rubber and NBR, as a base polymer; a silicone adhesive; and an acrylic adhesive. Of them, an acrylic adhesive is preferable. The base agents may be constituted of a single component or two or more components.

Examples of the acrylic adhesive include acrylic adhesives using an acrylic polymer such as mono or copolymers of esters of a (meth)acrylic acid and an alkyl including an ester of a C₁-C₂₀ alkyl and (meth)acrylic acid including methyl (meth)acrylate, ethyl (meth)acrylate, butyl (meth)acrylate, 2-ethylhexyl (meth)acrylate, and octyl (meth)acrylate; and copolymers of an ester of (meth)acrylic acid and an alkyl and another copolymerizable monomer [for example, a carboxyl group- or acid anhydride group-containing monomer such as acrylic acid, methacrylic acid, itaconic acid, fumaric acid and maleic anhydride; a hydroxyl group-containing monomer such as 2-hydroxyethyl (meth)acrylate; an amino group-containing monomer such as morpholyl (meth)acrylate; and an amide group-containing monomer such as (meth)acrylamide], as a base polymer. These can be used alone or in combination with two or more types.

Of them, a (meth) acrylate having a side chain of 1 to 10 carbon atoms, acrylic acid, 2-hydroxyethyl acrylate, 4-hydroxybutyl acrylate, acrylonitrile, acryloyl morpholine, N-phenyl maleimide and vinyl acetate are preferably used.
More specifically, polymers obtained by copolymerization of 2 to 4 types of monomers are preferably used. Examples of the polymers include a copolymer of ethyl acrylate, butyl acrylate and 2-hydroxyethyl acrylate;
a copolymer of ethyl acrylate, butyl acrylate, acrylic acid and 2-hydroxyethyl acrylate;
a copolymer of butyl acrylate and acrylic acid;
a copolymer of 2-ethylhexyl acrylate and acrylic acid;
a copolymer of 2-ethylhexyl acrylate and 2-hydroxyethyl acrylate
a copolymer of 2-ethylhexyl acrylate, acryloyl morpholine and 2-hydroxyethyl acrylate;
a copolymer of 2-ethylhexyl acrylate, acryloyl morpholine, 2-hydroxyethyl acrylate and acrylic acid;
a copolymer of ethyl acrylate, 2-ethylhexyl acrylate, N-phenylmaleimide and 2-hydroxyethyl acrylate;
a copolymer of 2-ethylhexyl acrylate, vinyl acetate and acrylic acid;
a copolymer of 2-ethylhexyl acrylate, vinyl acetate, acrylic acid and 2-hydroxyethyl acrylate;
a copolymer of butyl acrylate, vinyl acetate, acrylic acid and 2-hydroxyethyl acrylate;
a copolymer of butyl acrylate, acrylonitrile and acrylic acid;
a copolymer of butyl acrylate, acrylonitrile, acrylic acid and 2-hydroxyethyl acrylate;
a copolymer of ethyl acrylate, 2-ethylhexyl acrylate, methyl methacrylate and 2-hydroxyethyl acrylate;
a copolymer of 2-ethylhexyl acrylate, butyl acrylate, acrylic acid and 4-hydroxybutyl acrylate; and
a copolymer of 2-ethylhexyl acrylate, isobornyl acrylate and acrylic acid.

The energy-ray reactive functional group and energy-ray curable compound to be used in chemical modification for curing an energy-ray curable adhesive with an energy ray are not particularly limited as long as they can be cured with an energy ray such as infrared rays, visible rays, UV rays, X-rays and electron beams; however, the functional group and compound capable of effectively mediating three-dimensionally reticulation (networking) of the energy-ray curable adhesive with irradiation of an energy ray are preferable. These can be used alone or in combination with two or more types. Examples of energy-ray reactive functional group for use in chemical modification include functional groups having a carbon-carbon multiple bond such as an acryloyl group, a methacryloyl group, a vinyl group, an allyl group and an acetylene group. When these functional groups are irradiated with an energy ray, a carbon-carbon multiple bond is cleaved to produce radicals, which serve as crosslinking points for producing three-dimensional network structure. Of them, a (meth)acryloyl group is preferable in view of reactivity and workability since a (meth)acryloyl group can be highly reactive to an energy ray and (meth)acryloyl groups can be selected from many types of acrylic adhesives and used in combination.

Typical examples of a base agent chemically modified by an energy-ray reactive functional group include a polymer obtained by reacting a compound [e.g., (meth)acryloyloxyethylene isocyanate], which has a group reactive with the reactive functional group (e.g., an isocyanate group, an epoxy group) and an energy-ray reactive functional group (e.g., an acryloyl group, a methacryloyl group) within a molecule with a reactive functional group-containing acrylic polymer, which is obtained by copolymerizing a monomer containing a reactive functional group such as a hydroxyl group and a carboxyl group [for example, 2-hydroxyethyl (meth)acrylate, (meth)acrylate] with an ester of a (meth)acrylic acid and an alkyl.

In the reactive functional group-containing acrylic polymer, the ratio of the monomer containing a reactive functional group is for example 0.01 to 100 wt% relative to all monomers. In reacting with the reactive functional group-containing acrylic polymer, the use amount of compound which has a group reactive with a reactive functional group and an energy-ray reactive functional group within a molecule is, for example, 1 to 100 mole % and preferably 20 to 95 mole% relative to reactive functional group (hydroxyl group, carboxyl group and others) in the reactive functional group-containing acrylic polymer.

Examples of the energy-ray curable compound include an ester having a (meth)acryloyl group at a molecular end such as a (meth)acrylate, a urethane (meth)acrylate, an epoxy (meth)acrylate, a melamine (meth)acrylate and an acrylic resin (meth)acrylate, thiol-ene additional type resin having an allyl group at a molecule end and a photo cation polymerizable resin, a cinnamoyl group-containing polymer such as polyvinyl cinnamate, and a photosensitive reactive group-containing polymer or oligomer such as a diazotized amino novolak resin and an acrylamide polymer. Furthermore, examples of a polymer which becomes reactive with irradiation of a high energy ray include an epoxylated polybutadiene, an unsaturated polyester, a polyglycidyl methacrylate, a polyacrylamide and poly(vinyl siloxane).

Furthermore, examples of a polymer reacting with a high energy ray include compounds having two or more carbon-carbon double bonds such as poly (meth)acryloyl group-containing compounds including trimethylolpropane triacrylate, tetramethylolmethane tetraacrylate, pentaerythritol triacrylate, pentaerythritol tetraacrylate, dipentaerythritol monohydroxy pentaacrylate, dipentaerythritol hexaacrylate, 1,4-butanediol diacrylate, 1,6-hexanediol diacrylate and polyethylene glycol diacrylate. These compounds may be used alone or in combination with two or more types. Of them, a poly (meth)acryloyl group-containing compound is preferable. This is exemplified, for example in Japanese Patent Laid-Open No. 2003-292916. Hereinafter, the poly (meth)acryloyl group-containing compound will be sometimes referred to as an "acrylate crosslinking agent".

Furthermore, as the energy-ray curable compound, for example, a mixture of an organic salt such as an onium salt and a compound having a plurality of heterocyclic rings in a molecule can be used. When the mixture is irradiated with an energy ray, an organic salt is cleaved to produce ions, which serve as an initiation seed for inducing a ring-opening reaction of a heterocyclic ring to form a three-dimensional network structure. Examples of the organic salt include an iodonium salt, a phosphonium salt, an ammonium salt, a sulfonium salt and a borate salt. Examples of the heterocyclic ring in the compound having a plurality of heterocyclic rings in a molecule include oxirane, oxetane, oxolane, thiirane and aziridine. Specifically, the compounds described in Photo-Setting Technology (2000) edited by Technical Information Institute Co., Ltd., can be used.
Note that, if an energy-ray curable compound is used, the aforementioned base agent is not always necessary.

As the energy-ray curable adhesive, an adhesive, which is prepared from an acrylic polymer as mentioned above or an acrylic polymer chemically modified with an energy-ray reactive functional group (an acrylic polymer having an energy-ray reactive functional group introduced in a side chain) in combination with an energy-ray curable compound (e.g., a compound having two or more carbon-carbon double bonds) as mentioned above, is particularly preferable. The combination contains an acrylate group showing a relatively high reactivity to an energy ray and, in addition, can be selected from various types of acrylic adhesives. Thus, the combination is preferable in view of reactivity and workability. Specific examples of such a combination include a combination of an acrylic polymer having an acrylate group introduced in a side chain and a compound having two or more functional groups (particularly, an acrylate group) having a carbon-carbon double bond. As such a combination, those disclosed in e.g., Japanese Patent Laid-Open No. 2003-292916 can be used.

As a method for preparing the acrylic polymer having an acrylate group introduced in a side chain, for example, a method of binding an isocyanate compound, such as acryloyloxyethyl isocyanate and methacryloyloxyethyl isocyanate, to an acrylic polymer having a hydroxyl group in a side chain via a urethane bond can be used.

The content of the energy-ray curable compound falls, for example, within the range of about 0.001 to 500 parts by weight, preferably 0.01 to 200 parts by weight and further preferably about 0.1 to 150 parts by weight relative to 100 parts by weight of the base agent (e.g., an acrylic polymer as mentioned above, an acrylic polymer chemically modified with an energy-ray reactive functional group).

To the energy-ray curable adhesive, an energy-ray polymerization initiator for curing an energy-ray curable compound may be blended in order to improve the rate of a reaction for forming a three dimensional network structure.

As the energy-ray polymerization initiator, a known or conventional polymerization initiator can be appropriately selected depending upon the type of energy ray to be used (for example, infrared rays, visible rays, ultraviolet rays, X-rays, electron beams). In view of working efficiency, a compound capable of initiating a photopolymerization with UV rays is preferable. Examples of a typical energy-ray polymerization initiator include, but not limited to, ketone initiators such as benzophenone, acetophenone, quinone, naphthoquinone, anthraquinone and fluorenone; azo initiators such as azobisisobutyronitrile; and peroxide initiators such as benzoyl peroxide and perbenzoate. As a commercially available product, for example, "IRGACURE 184" and "IRGACURE 651" (trade names manufactured by BASF) are mentioned.

Energy-ray polymerization initiators can be used alone or in combination with two or more types. The content of the energy-ray polymerization initiator is usually about 0.01 to 10 parts by weight and preferably about 1 to 8 parts by weight relative to the above base agent (100 parts by weight). Note that, if necessary, an energy-ray polymerization accelerator may be used in combination with the energy-ray polymerization initiator.

To an energy-ray curable adhesive, other than the aforementioned components, appropriate additives such as a cross-linking agent, a curing (crosslinking) accelerator, an adhesion imparting agent, vulcanization agent and a thickener to obtain appropriate adhesiveness before and after curing with an energy ray, and appropriate additives such as an age resistor and an antioxidant to improve durability, are blended, if necessary.

Furthermore, as an adhesive constituting the adhesive layer 6, a non energy-ray curable adhesive containing an acrylic adhesive as mentioned above as a base agent can be used. In this case, the adhesive having a smaller adhesive force than detachment stress required for forming a cylindrical roll is available. For example, an adhesive having an adhesive force of 50 N/10 mm or less, preferably 25 N/10 mm or less and more preferably 10 N/10 mm or less, (as measured in a 180° peel detachment test (room temperature (25°C)) using a silicon mirror wafer as a workpiece) can be used.

As the non energy-ray curable adhesive containing an acrylic adhesive having a small adhesive force as a base agent, it is preferable to use an acrylic adhesive, which is prepared by adding a crosslinking agent capable of reacting with a reactive functional group [e.g., an isocyanate crosslinking agent, a melamine crosslinking agent, an epoxy crosslinking agent] to a copolymer, which is prepared by an ester of a (meth)acrylic acid and an alkyl [for example, an ester of (meth)acrylic acid and a C₁-C₂₀ alkyl, such as methyl (meth)acrylate, ethyl (meth)acrylate, butyl (meth)acrylate, 2-ethylhexyl (meth)acrylate and octyl (meth)acrylate], a monomer having a reactive functional group [for example, a carboxyl group or acid anhydride group-containing monomer such as acrylic acid, methacrylic acid, itaconic acid, fumaric acid and maleic anhydride; a hydroxyl group-containing monomer such as 2-hydroxyethyl (meth)acrylate; an amino group-containing monomer such as morpholyl (meth)acrylate; and an amide group-containing monomer such as (meth)acrylamide] and another optional copolymerizable monomer [for example, (meth)acrylate having an alicyclic hydrocarbon group such as isobornyl (meth)acrylate, and acrylonitrile] and crosslinking them.

The adhesive layer 6 is formed, for example, by a conventional method such as a method of applying a coating liquid, which is prepared by adding an adhesive, an energy-ray curable compound and an optional solvent, to a surface of the rigid film 4, and a method of applying the coating liquid to a proper detachment liner (separator) to form an adhesive layer and transferring the adhesive layer onto the rigid film 4. In the transferring method, voids may sometimes remain in the interface with the rigid film 4. In this case, a heating/pressurizing treatment is applied by e.g., an autoclave to disperse voids away. The adhesive layer 6 may be either a single layer or a multi-layer.

The thickness of the adhesive layer 6 is generally 1 to 200 µm, preferably 20 to 100 µm and further preferably 30 to 60 µm. If the thickness falls within the above range, the adhesive layer can acquire sufficient adhesive force to hold and provisionally immobilize a workpiece. This is excellent and favorable in view of economy and handling.

The self-rolling layered sheet of the present invention can be manufactured by laminating the thermal contraction film 2 and the rigid film 4 with the bonding-agent layer 3 interposed between them. At this time, a laminating means such as a hand roller and a laminator and an atmospheric pressure compression means such as an autoclave can be appropriately and optionally used in accordance with the purpose. Furthermore, the adhesive film of the present invention can be manufactured by providing the adhesive layer 6 on the surface of the rigid film 4 of the self-rolling laminate sheet or laminating the rigid film 4, on which the adhesive layer 6 is previously provided on one of the surfaces thereof, on the thermal contraction film 2 via the bonding-agent layer 3.

The adhesive film 5 of the present invention can be used, for example, as an adhesive sheet for protecting e.g., a semiconductor and an adhesive sheet for immobilizing e.g., a semiconductor wafer. The adhesive film 5 of the present invention is more specifically used as e.g., an adhesive sheet for back-grinding a silicone semiconductor, an adhesive sheet for back-grinding a compound semiconductor, an adhesive sheet for dicing a silicon semiconductor, an adhesive sheet for dicing a compound semiconductor, an adhesive sheet for dicing a semiconductor package, an adhesive sheet for dicing glass and an adhesive sheet for dicing ceramic; and particularly, useful as an adhesive sheet for a semiconductor such as an adhesive sheet for protecting a semiconductor and an adhesive sheet for immobilizing a semiconductor wafer.

Next, a method for processing a workpiece by use of the adhesive film of the present invention will be described. The adhesive film of the present invention is bonded to a workpiece to provisionally immobilize thereto. After a predetermined process is applied to the workpiece, the adhesive force of the adhesive layer of the adhesive film is lowered; at the same time, heat or the like is applied for contracting a thermal contraction film to allow the adhesive film to roll by itself unidirectionally (usually, along the main contraction axis) from an end of the adhesive film or from two ends facing each other toward the center (usually, along the main contraction axis) into one or two cylindrical shapes. In this way, the adhesive film is detached from the workpiece to obtain a processed product. Note that, when deformation takes place unidirectionally from an end of the adhesive film, a single cylindrical shape is formed (unidirectional rolling detachment). When self-rolling takes place from two ends facing each other of an adhesive film toward the center, two cylindrical shapes arranged in parallel next to each other are formed (bidirectional rolling detachment).

Typical examples of the workpiece include a semiconductor wafer formed of a compound such as silicon and GaAs and optical parts such as a filter, glass and quartz. Examples of the processing include grinding, cutting, polishing, etching, turning process and heating (however, if a contraction film is a thermal contractive film, the temperature is limited to a thermal contraction initiation temperature or less). The type of processing is not particularly limited as long as it can be applied to the adhesive film.

After processing of a workpiece, if e.g., an energy-ray curable adhesive layer is used as an adhesive layer, the adhesive layer is irradiated with an energy ray; at the same time, a thermal contraction film is heated by a predetermined heating means. As a result, the adhesive layer is cured and loses adhesive force and the thermal contraction film is going to contract and deform. Consequently, the outer edge portion of the adhesive film lifts up and starts to roll (or two outer edges facing each other start to roll). The adhesive film rolls unidirectionally by itself (or rolls in two mutually opposite directions (center direction)) to form a single cylindrical shape (or two cylindrical shapes). In this time, while the adhesive film can be controlled in contraction direction by a rigid film, the adhesive layer unidirectionally is rolled to immediately form a cylindrical shape. In this manner, the adhesive film can be extremely easily and finely detached from the workpiece. The heating temperature, which can be appropriately selected depending upon the contractility of a thermal contraction film, is, for example, 70 to 180°C and preferably 70 to 140°C. Irradiation of an energy ray and heat treatment may be performed simultaneously or stepwise. Furthermore, the surface of a workpiece can be wholly heated uniformly or stepwise. Furthermore, heating may be applied to a part of the surface just to trigger detachment. Heating treatment should be appropriately selected depending upon the purpose for taking advantage of easy-to-peel properties.

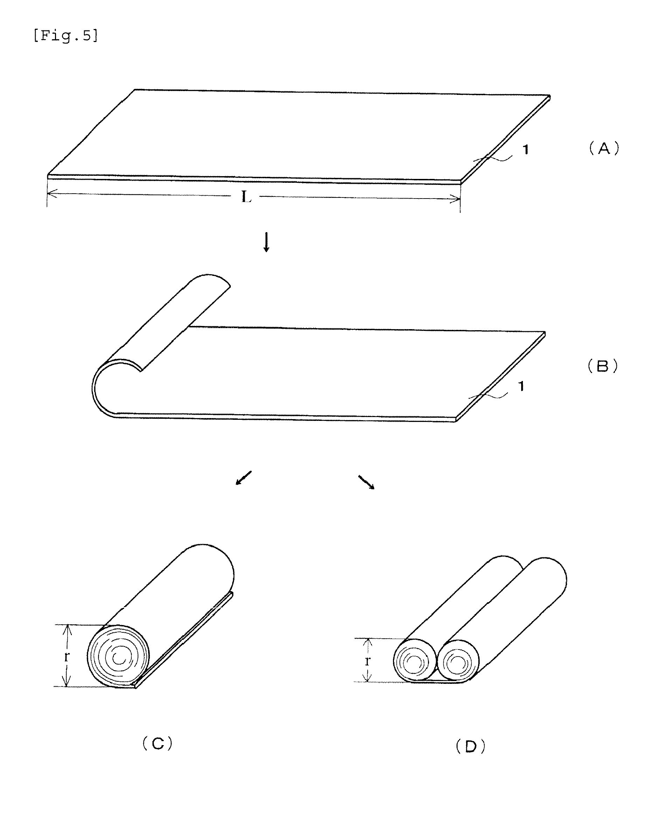

FIG. 5 is a (prospective) view showing how to deform the film or the self-rolling adhesive film of the present invention into a cylindrical shape. FIG. 5A shows a film or an adhesive film before a stimulus is applied, which causes contraction of the thermal contraction film. FIG. 5B shows the state where the film or the adhesive film (the adhesive force of the adhesive layer thereof is lowered or disappears), which has been stimulated by a stimulus causing contraction of the thermal contraction film, starts to unidirectionally (usually, in the main contraction axis direction of the thermal contraction film) roll from the sheet outer edge portion thereof (one end portion). FIG. 5C shows that the rolling of the sheet is completed to form a single cylindrical shape (unidirectional rolling).
FIG. 5D shows the state where the sheet deforms by itself from two end portions facing each other toward the center (usually, in the main contraction axis direction of the thermal contraction film) to form two cylindrical shapes (bidirectional rolling). Note that a film and an adhesive film prepared by providing an adhesive layer to the film have no substantial difference in deformability into a cylindrical shape. Whether the film or the self-rolling adhesive film rolls unidirectionally or bidirectionally is determined by e.g., the adhesive force of the rigid film to a thermal contraction film and Young's modulus or shearing storage elastic modulus of the rigid film (particularly, a bonding-agent layer).

In FIG. 5, reference symbol L indicates the length (diameter if the sheet is circular) of the film 1 or the adhesive film 5 in the rolling direction (usually, in the main contraction axis direction of the thermal contraction film) (FIG. 5A). Reference symbol r indicates the diameter of the formed cylindrical shape (indicates the maximum diameter if the diameter of the cylindrical shape is not constant in the length direction, as is in the case where the sheet is circular) (FIG. 5C, D). In the film or adhesive film of the present invention, the r/L value indicates how compactly the adhesive film rolls. The r/L value preferably falls within the range of 0.0001 to 0.999 and further preferably within the range of 0.001 to 0.333.
Note that, reference symbol L is, for example, 10 to 2000 mm, and preferably 300 to 1000 mm. The length of the side of the film or adhesive film in perpendicular to the side indicated by reference symbol L, is for example, 10 to 2000 mm and preferably about 300 to 1000 mm. The r/L value can be set to fall within the aforementioned range by controlling the type of material, composition and thickness of each of the thermal contraction film 2, the rigid film 4, the bonding-agent layer 3 and the adhesive layer 6, in particular, the shearing storage elastic modulus and thickness of the bonding-agent layer 3 constituting the rigid film 4, and the Young's modulus and thickness of the rigid film 4. In this example, the shape of the film or adhesive film is a square; however, the shape is not limited to this and appropriately selected depending upon the purpose. More specifically, the shape may be any one of e.g., circular, ellipsoidal, polygonal shapes.

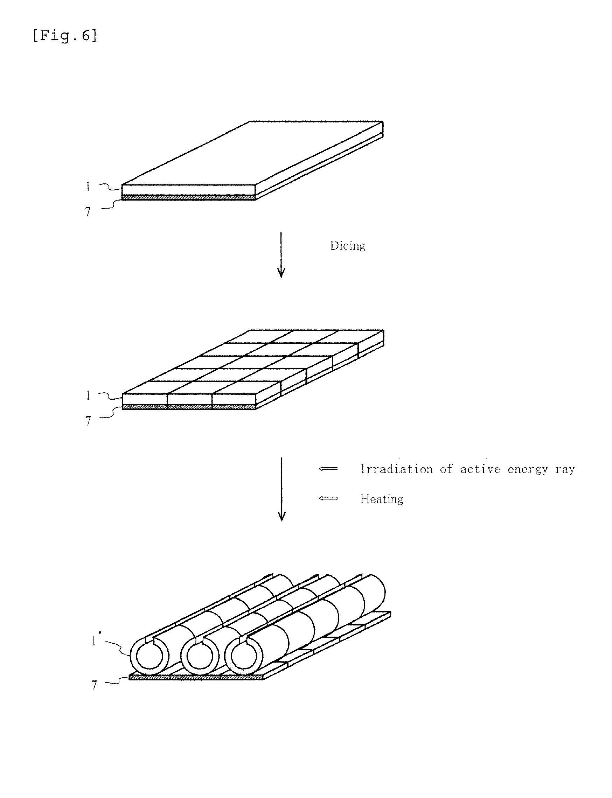

If a workpiece is processed by use of the adhesive film of the present invention, it is possible to avoid breakage of a workpiece by stress in detachment. More specifically, even if a fragile workpiece, such as a thin semiconductor wafer is processed, the adhesive film can be easily detached from the workpiece without breakage or contamination.
How to process is shown, for example, in FIG. 6. In the process shown in FIG. 6, the adhesive film of the present invention is bonded to a fragile surface of a workpiece. Thereafter, the workpiece is subjected to e.g., a dicing step. The adhesive film is detached from the workpiece by irradiation of e.g., active energy ray. The workpiece is further heated to contract the adhesive film cut together in the dicing step to deform the adhesive film into a cylindrical shape. Thereafter, from the surface of a workpiece, a cylindrically deformed adhesive film alone was removed to obtain a workpiece diced.

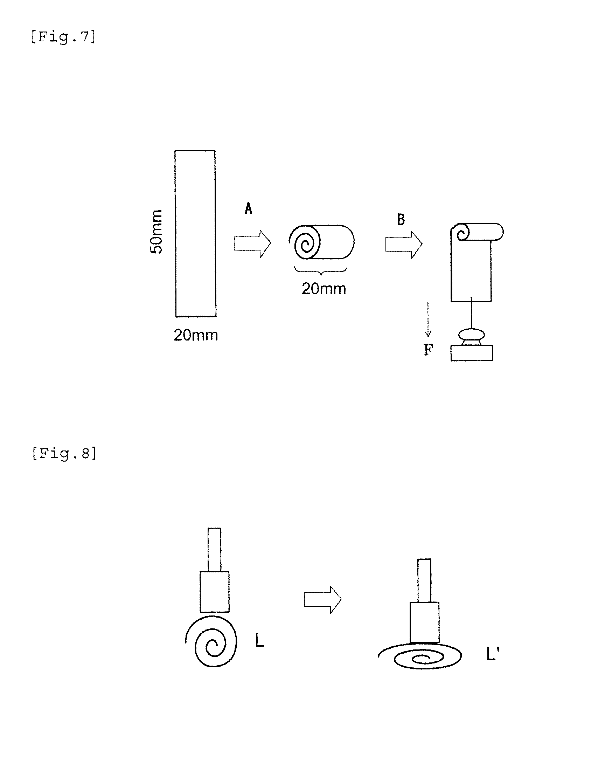

The present invention is directed to a film and an adhesive film formed of the aforementioned materials and layer structure and obtained by laminating a non-thermal contractive substrate on a thermal contraction film via a bonding-agent layer. Furthermore, the film needs to have the property of being not automatically returned to an original shape after the film is heated to form a cylindrical shape.
To confirm this property, the film is cut into pieces of 50 mm in length and 20 mm in width, as shown in FIG. 7. Each of the pieces is heated to obtain a cylindrical shape in step A. In step B, force F is applied to return the cylindrical shape into an original state (50 mm in length) before heating. If the force F exceeds 0.01 N, it can be determined that the cylindrical shape would not automatically return to an original shape.
The reason will be explained as follows. The cylindrical object acts as a spring. In order to return the cylindrical object to an original shape, force is required. The force varies depending upon the rigidity of the cylindrical object. More specifically, if the force required to return to an original shape exceeds 0.01 N, the film constituting the cylindrical object has high rigidity. Therefore, the film is bonded to a workpiece and then formed into a cylindrical object.
Even if the stress produced in the operation of detaching and removing the cylindrical object acts so as to crush the cylindrical object, the crushed product is not deformed into a shape which facilitates rebonding to the workpiece. Even if the cylindrical object bonds again to the workpiece, deformation restoration occurs due to high rigidity (elasticity) and the rebonded portion is detached. In this manner, collection of cylindrical object can be simplified. Furthermore, if the force is 0.05 N or more, a further rigid cylindrical object can be formed.
Note that, in the above, the size of the film is defined to be 50 mm in length and 20 mm in width. The size of the film is not limited to this. This is described just as an example.
Needless to say, if the size of the film differs, the required force varies depending upon the size of the film and the force required for returning a shape to obtain an original length before heating is different from 0.01 N.

As a physical property required for the film of the present invention required in order for the film of a cylindrical shape not to automatically return to original shape, a product of Young's modulus and thickness of the thermal contraction film may be 42000 N/m or more and further preferably 80000 N/m or more. This is because in order to serve as a strong spring, the materials constituting a laminated resin layer must have high rigidity.
As to the Young's modulus of the thermal contraction film, the following should be noted. Since the thermal contraction film is generally prepared by biaxial drawing, the film has in-plane anisotropy, which means that Young's modulus differs between in the length direction and the width direction of the film. Of Young's modulus values of the both directions, a higher value can be employed in the present invention.

Furthermore, as shown in FIG. 8, the film is cut into pieces of a size of 10 × 10 mm and heated to obtain cylindrical objects. Then a load is added to each of the cylindrical objects. If the load required for reducing the diameter (L) of an initial object to a diameter (L') after the load is applied, which is 1/2 of L, is 1 N or more, it means that the cylindrical object has a strong resistance to external stress and has sufficient hardness in detaching and removing it. Furthermore, if the force is 1.2 N or more, it can be said that the cylindrical object has more sufficient hardness in detaching and removing it.

Hereinafter, the effect of the present invention will be described based on Examples.

### Examples

### (Production Example of Adhesive)

### Adhesive 1

From an ethyl acetate solution containing a mixture of butyl acrylate and acrylic acid in a weight ratio of 100:3 (100 parts by weight) and a polymerization initiator, i.e., 2,2'-azobisisobutyronitrile (0.2 parts by weight), an acrylic polymer (weight average molecular weight: 1,100,000) was obtained by copolymerization.
To the obtained acrylic polymer (100 parts by weight), an isocyanate compound (trade name: CORONATE L, manufactured by Nippon Polyurethane Industry Co., Ltd.) (2 parts by weight) and an epoxy compound (trade name: TETRAD-C, manufactured by Mitsubishi Gas Chemical Company Inc.) (0.4 parts by weight) were added to obtain adhesive 1.

### Adhesive 2

From an ethyl acetate solution containing a mixture of 2-ethylhexyl acrylate and acrylic acid in a weight ratio of 100: 5 (100 parts by weight) and a polymerization initiator, i.e., benzyl peroxide (0.2 parts by weight), an acrylic polymer (weight average molecular weight: 1,000,000) was obtained by copolymerization.
To the obtained acrylic polymer (100 parts by weight), an isocyanate compound (trade name: CORONATE L, manufactured by Nippon Polyurethane Industry Co., Ltd.) (1.5 parts by weight) and a melamine compound (trade name: Super-beckamine J-820, manufactured by DIC Corporation) (0.5 parts by weight) were added to obtain adhesive 2.

### Adhesive 3

From a toluene solution of a mixture (100 parts by weight) containing 2-ethylhexyl acrylate and 2-hydroxyethyl acrylate in a weight ratio of 85: 15, to which a polymerization initiator, benzyl peroxide (0.2 parts by weight) was added, an acrylic polymer (weight average molecular weight: 570,000) was obtained by copolymerization.
To the obtained acrylic copolymer, 2-isocyanatoethyl methacrylate (trade name :Karenz MOI manufactured by SHOWA DENKO K. K.) containing a hydroxyl group derived from 2-hydroxyethyl acrylate in an amount of 80 mole % and dibutyltin dilaurate in an amount of 0.05 parts by weight relative to the acrylic polymer (100 parts by weight) were blended and reacted under air at 50°C for 12 hours to obtain an acrylic polymer having a methacrylate group in the side chain.
To the obtained acrylic polymer (100 parts by weight), a radical photopolymerization initiator (IRGACURE 651, 2,2-dimethoxy-1,2-diphenylethan-1-one, manufactured by BASF)(1.5 part by weight) and an isocyanate compound (trade name, CORONATE L, manufactured by Nippon Polyurethane Industry Co., Ltd.)(1.8 parts by weight) were added to obtain energy-ray curable adhesive 3.

### Adhesive 4

From an ethyl acetate solution of a mixture (100 parts by weight) containing butyl acrylate and acrylic acid in a weight ratio of 100: 5, to which a polymerization initiator, benzyl peroxide (0.2 parts by weight) was added, an acrylic polymer (weight average molecular weight: 1,250,000) was obtained by copolymerization.
To the obtained acrylic polymer (100 parts by weight), an isocyanate compound (trade name, CORONATE L, manufactured by Nippon Polyurethane Industry Co., Ltd.)(2 parts by weight) and an epoxy compound (trade name TETRAD-C, manufactured by Mitsubishi Gas Chemical Company Inc.)(0.5 parts by weight) were added to obtain adhesive 4.

### Adhesive 5

From a toluene solution of mixture of ethyl acrylate, 2-ethylhexyl acrylate, methyl methacrylate and 2-hydroxyethyl acrylate in a weight ratio of 70:30:5:4 (100 parts by weight) and a polymerization initiator, i.e., benzyl peroxide (0.2 parts by weight), an acrylic polymer (weight average molecular weight: 480,000) was obtained by copolymerization.
To the obtained acrylic polymer (100 parts by weight), an isocyanate compound (trade name: CORONATE L, manufactured by Nippon Polyurethane Industry Co., Ltd.) (2 parts by weight) and a tin catalyst (trade name: EMBILIZER OL-1, manufactured by Tokyo Fine Chemical CO., LTD)(0.025 parts by weight) were added to obtain adhesive 5.

### Adhesive 6

From an ethyl acetate solution of a mixture (100 parts by weight) containing ethyl acrylate, butyl acrylate, acrylic acid and 2-hydroxyethyl acrylate in a weight ratio of 30:70:5:1, to which a polymerization initiator, 2,2'-azobisisobutyronitrile (0.2 parts by weight) was added, an acrylic polymer (weight average molecular weight: 1,000,000) was obtained by copolymerization.
To the obtained acrylic polymer (100 parts by weight), an isocyanate compound (trade name, CORONATE L, manufactured by Nippon Polyurethane Industry Co., Ltd.)(2 parts by weight) and an epoxy compound (trade name TETRAD-C, manufactured by Mitsubishi Gas Chemical Company Inc.)(0.5 parts by weight) were added to obtain adhesive 6.

### Adhesive 7

To an acrylic copolymer (trade name: "Rheocoat R1020S", manufactured by Dai-ichi Lace Company) (100 parts by weight), an isocyanate compound (trade name: CORONATE L, manufactured by Nippon Polyurethane Industry Co., Ltd.) (2 parts by weight) and an epoxy compound (trade name: TETRAD-C, manufactured by Mitsubishi Gas Chemical Company Inc.) (0.5 parts by weight) were added to obtain adhesive 7.

### Adhesive 8

From an ethyl acetate solution of a mixture (100 parts by weight) containing methyl acrylate, 2-ethylhexyl acrylate and acrylic acid in a weight ratio of 70:30:10, to which a polymerization initiator, benzoyl peroxide (0.2 parts by weight) was added, an acrylic polymer (weight average molecular weight: 830,000) was obtained by copolymerization.
To the obtained acrylic polymer (100 parts by weight), an isocyanate crosslinking agent (trade name, CORONATE, manufactured by Nippon Polyurethane Industry Co., Ltd.)(3 parts by weight), an epoxy crosslinking agent (trade name TETRAD-C, manufactured by Mitsubishi Gas Chemical Company Inc.) (0.75 parts by weight), a multifunctional urethane acrylate oligomer (trade name KAYARAD DPHA-40H manufactured by Nippon Kayaku Co., Ltd.,)(50 parts by weight) and a photopolymerization initiator (trade name "IRGACURE 651" manufactured by BASF)(3 parts by weight) were added to obtain adhesive 8.

### Adhesive 9 (for Comparative Example 1)

From a solution mixture of toluene and ethyl acetate in a weight ratio of 80/20 (weight ratio) containing a mixture of n-butyl acrylate, acrylic acid, vinyl acetate and 2-hydroxyethyl acrylate in a weight ratio of 100:3:5:0.1 (100 parts by weight) and a polymerization initiator, i.e., 2,2'-azobisisobutyronitrile (0.2 parts by weight), an acrylic copolymer (weight average molecular weight: 600,000) was obtained.
To the obtained acrylic copolymer (100 parts by weight), a terpene phenol resin (Mighty Ace G-150, manufactured by YASUHARA CHEMICAL Co., Ltd.)(10 parts by weight), a polymerized rosin pentaerythritol ester (trade name: Pensel D-125, manufactured by Arakawa Chemical Industries Ltd.)(10 parts by weight), a hydrogenated rosin ester (trade name: Ester gum H manufactured by Arakawa Chemical Industries Ltd.)(10 parts by weight), a hydrogenated rosin methyl ester (trade name: Foralyn 5020F, manufactured by Eastman Chemical Company) (5 parts by weight), an isocyanate compound (trade name: CORONATE L manufactured by Nippon Polyurethane Industry Co., Ltd.)(1.4 parts by weight) were added to obtain adhesive 9.

### Adhesive 10 (Adhesive prepared for measuring shear stress)

From an ethyl acetate solution containing a mixture of methyl acrylate, 2-ethylhexyl acrylate, and acrylic acid in a weight ratio of 70:30:10 (100 parts by weight) and a polymerization initiator, i.e., benzyl peroxide (0.2 parts by weight), an acrylic polymer (weight average molecular weight: 1,200,000) was obtained by copolymerization.
To the obtained acrylic polymer (100 parts by weight), an isocyanate compound (trade name: CORONATE L, manufactured by Nippon Polyurethane Industry Co., Ltd.)(3 parts by weight) and a multifunctional acrylate compound (trade name: DPHA-40H, manufactured by Nippon Kayaku Co., Ltd.)(60 parts by weight) were added to obtain adhesive 10.

### (Production Example of film for self-rolling adhesive film)

As a rigid film, a polyethylene terephthalate (PET) film (Lumilar S105 (thickness: 38 µm) manufactured by Toray Industries Inc., one of the surfaces was treated with corona) was used.
The surface of the rigid film layer treated with corona was coated with NB300 (containing a light blue pigment, manufactured by Dainichiseika Color & Chemicals, Mfg. Co., Ltd.,) so as to have a thickness (dry basis) of 1 to 2 µm by a gravure coater and dried to obtain a rigid film provided with an organic coating layer.
The surface of the rigid film layer opposite to the organic coating layer and the corona treated surface of a thermal contraction polyester film (Space clean S7200 of 30 µm in film thickness, one of the surfaces was treated with corona, manufactured by Toyobo Co., Ltd.) were bonded with a bonding agent by a dry laminate method to prepare a self-rolling film substrate.
Note that the bonding agent used in dry laminate was prepared by blending Takerak A520, Takenate A10 (manufactured by Mitsui Chemicals, Inc.) and ethyl acetate in a weight ratio of 6:1:5.5. Furthermore, the thickness of the bonding agent (dry basis) was 2 to 4 µm.

### (Examples of self-rolling adhesive film)

### Example 1

Adhesive 1 was applied to a PET surface treated with silicone (treated with release silicone) by a die coater so as to obtain a film thickness (in a dry basis) of 40 µm and thereafter bonded to the organic coating layer of a film for a self-rolling adhesive film obtained in a production example to obtain self-rolling adhesive film 1.

### Example 2

Adhesive 2 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 2.

### Example 3

Adhesive 3 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 3.

### Example 4

Adhesive 4 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 4.

### Example 5

Adhesive 5 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 5.

### Example 6

Adhesive 6 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 6.

### Example 7

Adhesive 7 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 7.

### Example 8

Adhesive 8 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 8.

### Comparative Example 1

Adhesive 9 was applied to a PET surface treated with silicone (treated with release silicone) by a die coater so as to obtain a film thickness (in a dry basis) of 40 µm and then bonded to the organic coating layer of a film substrate obtained in a production example to obtain self-rolling adhesive film 9.

### [Measurement of shear stress]

How to measure shear stress is schematically shown in FIG. 4.
Method of preparing a test piece for measuring shear stress
Support plate 11 (silicon wafer) of 5 mm × 5 mm was bonded to a rigid film layer (organic coating layer side) of a film for a self-rolling adhesive film with an adhesive (adhesive production example, adhesive 11) to form laminate A.
Support plate 12 (silicon wafer) of 70 mm × 70 mm was bonded to a thermal contraction film of a self-rolling adhesive film obtained in each of Examples and Comparative Example with two-sided tape 8 (No. 5015 manufactured by NITTO DENKO CORPORATION) to form laminate B.
Next, the thermal contraction film layer of laminate A and the adhesive layer of laminate B were bonded, pressurized (nip pressure: 0.35 MPa, laminate rate: 1 m/minute) by a laminator and treated in an autoclave (40°C × 5 minutes, 0.5 MPa) to prepare a test piece.

### [Measurement of shear stress]

The shear stress produced in the interface between the adhesive layer (each of Examples 1 to 3 and Comparative Example 1) and a thermal contraction film was measured by moving the laminate A of a test piece by a load cell in the shearing direction by use of a shear stress measuring apparatus: DAGE-SERIES-4000 PXY (manufactured by Dage Precision Industries Ltd.).
Note that the measurement conditions (parameters) of the measuring apparatus are as follows:
· Load cell: DS 100 kg
· Test type: Breaking test
· Test speed (load cell moving rate): 500 µm/s
· Lower-limit standard value: 0.5 kg
· Test height: 425 µm
· Temperature control of stage: None

### [Roll-detachment time and measurement of r/L value]

To an 8-inch mirror wafer, a self-rolling adhesive film obtained in each of Examples and Comparative Example was bonded. Thereafter, the wafer (in the range from the edge of the wafer up to 50 mm) was brought into contact with a hot plate of 90°C and heated. In this manner, the time from initiation of detachment to completion of detachment was measured.
After completion of the detachment, the diameter r of a cylindrical object produced by detachment was measured by a ruler and divided by L (50 mm) to obtain a value of r/L.
Note that a self-rolling adhesive film using an energy-ray curable adhesive was irradiated with UV rays so as to obtain about 500 mJ/cm² before measurement and it was used.

### [Determination of Young's modulus (80°C) of rigid film layer]

The Young's modulus of a rigid film layer was determined by the following method in accordance with JIS K7127. As a tensile tester, autograph AG-1kNG (equipped with warming hood) manufactured by Shimadzu Corporation. The rigid film was cut into test pieces (rigid film) of 200 mm in length × 10 mm in width. Each of the test pieces (rigid film) was provided between chucks having a distance of 100 mm. After the temperature of the ambient atmosphere was increased by the warming hood to 80°C, the test piece was pulled at a tension rate of 5 mm/minute to obtain distortion values. From the measurement values, a stress-distortion correlation was obtained. At two points showing distortion values of 0.21 and 0.45%, loads were read out to obtain Young's modulus. The measurement of a test piece was repeated 5 times and an average value thereof was employed.

### [Measurement of detachment force between thermal contraction film and rigid film]

The films for a self-rolling adhesive film obtained in Manufacturing Examples were cut into pieces of 70 mm in length × 10 mm in width. The surface of the rigid film layer (on the side of organic coating layer) and a silicon wafer serving as a rigid support substrate were bonded with a double-faced adhesive film (trade name No. 5000N manufactured by NITTO DENKO CORPORATION). The bonded product was placed on a warmed stage of 70°C such that the rigid support substrate was in contact with the stage.
The surface of the contractive film layer and a pulling jig of a peel detachment tester were connected with an adhesive film so as to obtain a peel angle of 180°.
The pulling jig was pulled lengthwise at a tension rate of 300 mm/minute. The force (N/10 mm) was measured at the time the contractive film layer detached from the bonding-agent layer.

### [Method for evaluating breakage of wafer]

To a 8-inch mirror wafer, a self-rolling adhesive film obtained in each of Examples and Comparative Example was bonded. Thereafter, the rear surface of the wafer was polished so as to obtain a wafer thickness of 75 µm by a back grinder (apparatus name: DFG 8560 manufactured by DISCO Corporation).
Next, the wafer (in the range from the edge of the wafer up to 50 mm) was brought into contact with a hot plate of 90°C and heated. A self-rolling adhesive film detached without a breakage of a wafer was evaluated as ○ and a self-rolling adhesive film detached with a breakage of wafer was evaluated as X.
Note that the surface of adhesive tape 3 obtained in Example 3 was irradiated with UV rays (cumulative light amount: 300 mJ/cm²) after polishing the rear surface of a wafer to harden the adhesive layer and subjected to the aforementioned detachment operation.

### [Evaluation results]

**[Table 1]**

| | Example 1 | Example 2 | Example 3 | Example 4 | Example 5 | Example 6 | Example 7 | Example 8 | Comparative Example 1 |
|---|---|---|---|---|---|---|---|---|---|
| Adhesive | Adhesive 1 | Adhesive 2 | Adhesive 3 | Adhesive 4 | Adhesive 5 | Adhesive 6 | Adhesive 7 | Adhesive 8 | Adhesive 9 |
| Rigid-film thickness (µm) | 38 | 38 | 38 | 38 | 38 | 38 | 38 | 38 | 38 |
| Rigid-film Young's modulus (80°C) (GPa) | 3.72 | 3.72 | 3.72 | 3.72 | 3.72 | 3.72 | 3.72 | 3.72 | 3.72 |
| Rigid-film Young's modulus × thickness (N/m) | 141000 | 141000 | 141000 | 141000 | 141000 | 141000 | 141000 | 141000 | 141000 |
| Detachment force between thermal contraction film and rigid film (70°C) (N/10 mm) | 4.3 | 4.3 | 4.3 | 4.3 | 4.3 | 4.3 | 4.3 | 4.3 | 4.3 |
| Shear stress (g/mm²) | 82.7 | 157.3 | 81.2 | 91.6 | 120.4 | 88.7 | 197.2 | 8.0 or less | 243.9 |
| Detachment time (second) | 123 | 191 | 5 | 30 | 150 | 179 | 107 | 324 | Unmeasurable |
| r Value (mm) | 4 | 4 | 5 | 4 | 4 | 4 | 4 | 5 | Unmeasurable |
| r/L | 0.08 | 0.08 | 0.1 | 0.08 | 0.08 | 0.08 | 0.08 | 0.1 | Un- |
| | | | | | | | | | measurable |
| Presence or absence of breakage of wafer | ○ | ○ | ○ | ○ | ○ | ○ | ○ | ○ | × |

In Examples 1 to 8, a film was detached while deforming into a cylindrical shape without the aforementioned failures. Detachment was completed without breaking a 75 µm-thick wafer. In Comparative Example 1, detachment was stopped at the time the adhesive layer came into contact with the thermal contraction film at a distance of 28 mm from the detachment initiation end. Therefore, detachment time and an r/L value were not obtained. Furthermore, in the detachment from a 75 µm-thick wafer, heating was continued even after detachment was stopped by contact of the adhesive layer with the thermal contraction film, and wafer was broken.
Such difference in the results between Examples 1 to 8 and Comparative Example 1 is influenced by a shear stress value, as is apparent from comparison particularly between Example 7 and Comparative Example 1.

- 1: Film
- 2: Thermal contraction film
- 3: Bonding-agent layer
- 4: Rigid film
- 5: Adhesive film
- 6: Adhesive layer
- 7: Adhesive layer
- 8: Double-faced film
- 9: Workpiece
- 10: Contact point
- 11: Support plate
- 12: Support plate

## Claims

1. A self-rolling adhesive film comprising an adhesive layer laminated on a substrate film comprising a laminate having a thermal contraction film as one of the surfaces thereof, wherein the adhesive layer is laminated on a surface of the substrate film, not formed of the thermal contraction film, and shear stress between the surface of the thermal contraction film and the adhesive layer is 240 g/mm² or less.

2. The self-rolling adhesive film according to Claim 1, wherein the thermal contraction film has a contraction percentage of 30 to 90% in a main contraction direction at a predetermined temperature within the range of 70 to 180°C.

3. The self-rolling adhesive film according to Claim 1, wherein the multi-layered substrate comprises a rigid film and the rigid film has a product obtained by multiplying Young's modulus at 80°C and a thickness thereof of 3.0 × 10⁵ N/m or less.

4. The self-rolling adhesive film according to Claim 3, wherein the thermal contraction film has a contraction percentage of 30 to 90% in a main contraction direction at a predetermined temperature within the range of 70 to 180°C and a product obtained by multiplying Young's modulus of the rigid film at 80°C and a thickness thereof is 3.0 × 10⁵ N/m or less.

5. The self-rolling adhesive film according to Claim 1, rolling by itself unidirectionally from one end or from two ends facing each other toward the center by heating to form one or two cylindrical rolls.

6. The self-rolling adhesive film according to Claim 1, wherein a ratio of (r/L), which is a ratio of diameter r of the cylindrical roll to be formed and the original length L of the self-rolling adhesive film cylindrically rolled, is 0.0001 to 0.999.

7. The self-rolling adhesive film according to any one of Claims 1 to 6, obtained by sequentially laminating the thermal contraction film, the bonding-agent layer, the rigid film and the adhesive layer in this order.

8. The self-rolling adhesive film according to any one of Claims 1 to 6 including an organic coating layer between the rigid film and the adhesive layer.

9. The self-rolling adhesive film according to any one of Claims 1 to 6, wherein the adhesive layer is energy-ray curable.

10. The self-rolling adhesive film according to any one of Claims 1 to 6, wherein detachment force (180° detachment by peel strength, tension rate: 300 mm/minute) required for detachment between the thermal contraction film and the rigid film at 70°C is 2.0 N/10 mm or more.

11. A method for processing a workpiece, comprising bonding the self-rolling adhesive film according to any one of Claims 1 to 10 to a workpiece, reducing the thickness of the workpiece surface on which the self-rolling adhesive film is not bonded, heating the self-rolling adhesive film to roll the self-rolling adhesive film, thereby detaching the self-rolling adhesive film from the workpiece.

12. A method for processing a workpiece, comprising bonding the self-rolling adhesive film according to any one of Claims 1 to 10 to a workpiece, cutting the workpiece, heating the self-rolling adhesive film to roll the self-rolling adhesive film, thereby detaching the self-rolling adhesive film from the workpiece.
